# EUROPEAN PATENT APPLICATION

(11) **EP 2 650 603 A1**
(43) Date of publication of application: **16.10.2013**
(21) Application number: 10857720.6
(22) Date of filing: 11.11.2010
(51) Int. Cl.: F21V 7/00, F21V 23/06, H01L 33/52, F21Y 101/02

(54) **PACKAGE STRUCTURE OF LED LIGHT SOURCE MODULE**

(30) Priority: 30.09.2010 CN 201010299593
(71) Applicant: Fujian Zhongkewanbang Photoelectric Shares Co. Ltd, Putian, Fujian 351100 (CN)
(72) Inventor: HE, Wenming, Putian Fujian 351100 (CN)
(74) Representative: Gregersen, Niels Henrik
(86) International application number: PCT/CN2010/078621
(87) International publication number: WO 2012/040957

(57) **Abstract**

A package structure of LED light source module comprises a metal substrate (1), a circuit board (2), reflective cups (3), and LED chips (4). The circuit board (2) is embedded in the lower surface of the metal substrate (1). At least one reflective cup (3) is on the upper face of the metal substrate (1). A pinhole (12) leading to the upper surface of the circuit board (2) is provided at the bottom of each reflective cup (3). At least one LED chip (4) is mounted in each of the reflective cups (3). The LED chips (4) are stuck on the portion of metal substrate (1) where the pinhole (12) does not exist at the bottom of the reflective cups (3) by insulating adhesive, and are connected to the circuit board (2) through wires (6) passing through the pinhole (12). A mixed layer (5) of glue and phosphor is coated on the upper surfaces of the LED chips (4).

## Description

### Field of the Invention

The present invention refers to a lighting equipment, especially refers to a LED light source module.

### Prior art

LED is a kind of light source of low voltage, it has been widely applied to various of low-voltage lighting equipments due to its power saving and long lifetime. Traditional package structures of high-power LED chips or highly integrated multi-chips LED light source module commonly employ metal substrates. In specific structures, high thermal conductive metal (such as copper, aluminum, etc.) with reflective cups is often used as substrates, and then an insulating layer and a circuit layer are compounded on the substrate, which forms an integrated composite substrate. LED chips are installed in the centre of the reflective cups, and connected to circuit layer, and then a mixed layer of glue and phosphor is coated on the upper surface of the LED chips to complete the package. In the above-mentioned traditional package structure of LED light source module, lead wires are required between LED chips and circuit layer, however, LED chips are fixed inside the reflective cup, while the circuit board is configured outside the reflective cup, thus during manufacturing, lead wires between LED chips and the circuit layer are easy to be damaged due to touching off by accident, which significantly reduces production efficiency, furthermore, the production process becomes more complicated, increasing production cost, and heat dissipate rate of the whole package structure is low because a large scale of insulating layer is needed in traditional metal substrate, and it will lead to short lifetime of product.

### Technology of the invention

A technical problem to be solved in the present invention is to provide a new type of package structure of LED light source module with better thermal properties and saving production cost.

The present invention is achieved through the following structures:

A new type of package structure of LED light source module comprises a metal substrate, a circuit board, reflective cups, and LED chips, wherein the circuit board is embedded in the lower surface of the metal substrate; at least one reflective cup is fixed on the upper surface of the metal substrate, and a pinhole leading to the upper face of the circuit board is provided at the bottom of each reflective cup; at least one LED chip is mounted in each of the reflective cups, the LED chips are stuck on the portion of metal substrate where the pinhole does not exist at the bottom of the reflective cups by insulating adhesive, and a mixed layer of glue and phosphor is coated on the upper surface of the LED chips, and LED chips are connected to the circuit board through wires passing through the pinhole.

An elongated groove is configured on the lower surface of the metal substrate, and the circuit board is embedded in the elongated groove.

An electroplated plating reflective layer is provided on the upper surface of said metal substrate.

The reflective cups are annular, and they are formed through injection molding or dotted molding, or through die-casting directly on the metal substrate.

At least one button is provided at one end of the metal substrate, and a matching slot is arranged correspondingly at the other end.

The invention has the following merits:
LED chips, circuit board and wires between them are encapsulated under the mixed layer of glue and phosphor applying the package mentioned above, which could be accomplished in one step during packaging process of LED chips, and it leads to significantly improved production efficiency, reduced damage of wires during production and saving production cost; due to the production process is significantly simplified without sacrificing firm fixation, because the circuit board is embedded into the preset slot installed on the back of the metal substrate directly; furthermore, the properties of heat dissipating is improved due to LED chips being fixed on the metal substrate directly, and the lifetime of product is prolonged.

### Description of the Drawing

The invention will be further described by embodiments with reference to the accompanying drawings.
Figure 1 is a top view of structure schematic drawing of the package structure of LED light source module of the present invention.
Figure 2 is a bottom view of structure schematic drawing of the package structure of LED light source module of the present invention.
Figure 3 is a front view of structure schematic drawing of the package structure of LED light source module of the present invention.
Figure 4 is a right view of structure schematic drawing of the package structure of LED light source module of the present invention.
Figure 5 is a schematic drawing illustrating a connection between the metal substrate, the circuit board and LED chips of the package structure of LED light source module of the present invention.
Figure 6 is an A-A sectional view of figure 1.

### Embodiments

The present invention will be disclosed in detailed description with reference to the specific examples.

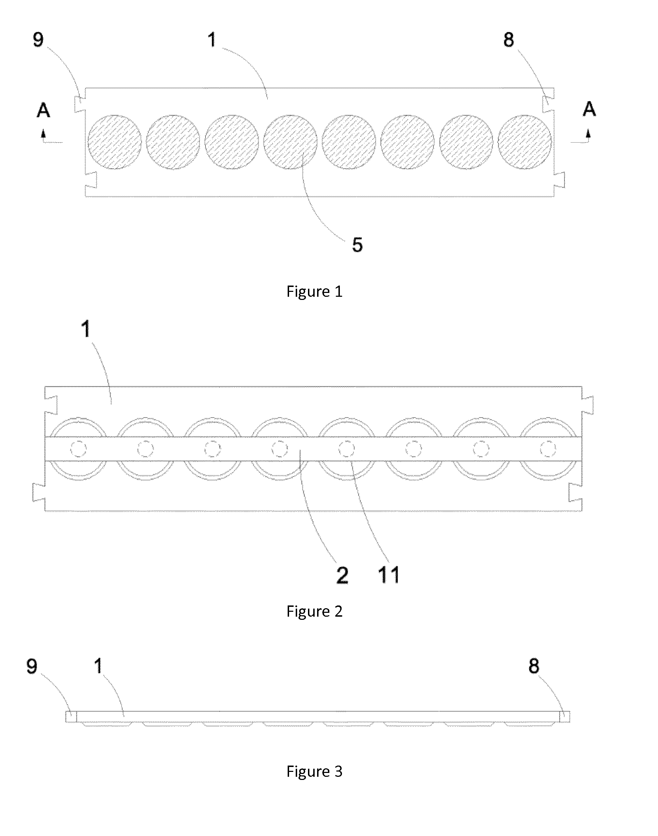

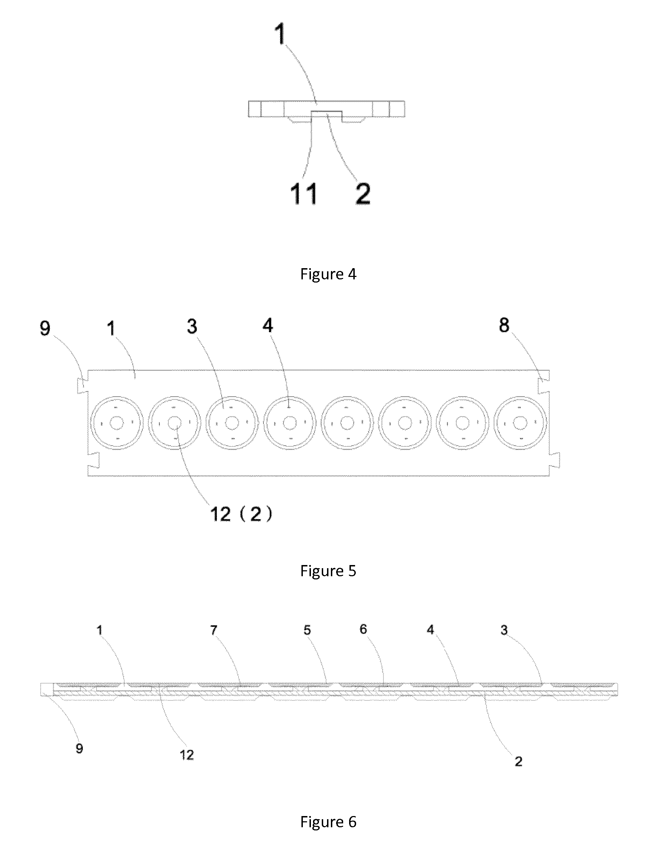

As shown in Figure 1 to 6, it is illustrated the package structure of LED light source module of the present invention, comprising a metal substrate 1, a circuit board 2, reflective cups 3, and LED chips 4, wherein an elongated groove 11 is configured in the middle of the lower surface of the metal substrate 1, the circuit board 2 is embedded in the elongated groove 11; a connecting circuit prepared in advance is arranged on the circuit board 2, both ends of the circuit board 2 are extended to both ends of the metal substrate 1 to form positive/negative electrode; the reflective cups 3 are directly die-cast molded on the metal substrate 1; a pinhole 12 leading to the upper face of the circuit board 2 is provided at the bottom of reflective cup 3, and several LED chips 4 are mounted in each of the reflective cups 3, the LED chips 4 are stuck on the portion of metal substrate 1 where the pinhole 12 does not exist at the bottom of the reflective cups 3 by insulating adhesive; a mixed layer 5 of glue and phosphor is coated on the upper surface of the LED chips 4; LED chips 4 are connected to the circuit board 2 by wires 6 passing through the pinhole 12. An electroplated reflective layer 7 is provided on the upper surface of the metal substrate 1, the reflective layer is a silver coating in this embodiment; the reflective cups 3 are annular, and it is round in this embodiment, the reflective cup 3 is fixed on the metal substrate 1 after it is formed through injection molding or dotted molding.. In the present invention, the groove can be omitted on the lower surface of the metal substrate 1, and the objective of the present invention could also be achieved by fixing the circuit board 2 on the lower surface of the metal substrate 1 directly instead. Alternatively, the invention can also be performed using a quadrate reflective cup. A expanding button 8 is provided at one end of the metal substrate 1, and a slot 9 with the same shape as the button is located correspondingly at the other end, it is also feasible to arrange more buttons and slots in such way on both ends, for purpose of connecting numbers of identical modules together easily, for example, applied for long strip light bars.

## Claims

1. A package structure of LED light source module, comprising a metal substrate, a circuit board, reflective cups, and LED chips, wherein said circuit board is embedded on the lower surface of said metal substrate; at least one reflective cup is on the upper surface of said metal substrate, a pinhole leading to the upper surface of said circuit board is provided at the bottom of said reflective cup; at least one LED chip is mounted in each of the reflective cups, the LED chips are stuck on the portion of metal substrate where said pinhole does not exist at the bottom of said reflective cups by insulating adhesive, a mixed layer of glue and phosphor is coated on the upper surface of said LED chips, and said LED chips are connected to said circuit board through wires passing through said pinhole.

2. A package structure of LED light source module according to claim 1, wherein an elongated groove is configured on the lower surface of said metal substrate, and said circuit board is embedded in said elongated groove.

3. A package structure of LED light source module according to claim 1, wherein an electroplated reflective layer is provided on the upper surface of said metal substrate.

4. A package structure of LED light source module according to claim 1, wherein said reflective cups are annular, and they are formed through injection molding or dotted molding, or through die-casting directly on said metal substrate.

5. A package structure of LED light source module according to claim 1, wherein at least one button is provided at one end of said metal substrate, and a matching slot is provided correspondingly at the other end.
